# EUROPEAN PATENT SPECIFICATION

(11) **EP 0 457 998 B1**
(45) Date of publication and mention of the grant of the patent: **26.01.1994**
(21) Application number: 90810383.1
(22) Date of filing: 25.05.1990
(51) Int. Cl.: B28D 5/00, H01L 21/00

(54) **Method and apparatus for batch cleaving semiconductor wafers and for coating the cleaved facets**
Verfahren und Vorrichtung zum Spalten von Halbleiterplatten und Bekleiden der gespalteten Facetten
Procédé et dispositif pour le clivage des plaquettes semi-conductrices et pour le revêtement des facettes clivées

(43) Date of publication of application: 27.11.1991
(73) Proprietor: International Business Machines Corporation, Armonk, N.Y. 10504 (US)
(72) Inventor: Broom, Ronald F., Dr., CH-8002 Zürich (CH); Gasser, Marcel, CH-8041 Zürich (CH); Harder, Christoph, Dr., CH-8038 Zürich (CH); Latta, Ernst-Eberhard, Dr., CH-8134 Adliswil (CH); Oosenbrug, Albertus, CH-8135 Langnau am Albis (CH); Richard, Heinz, CH-8802 Kilchberg (CH); Vettiger, Peter, CH-8135 Langnau am Albis (CH)
(74) Representative: Barth, Carl Otto

(56) References cited:
- DE-A- 1 427 717
- DE-A- 2 115 306
- US-A- 2 180 837
- US-A- 4 195 758
- US-A- 4 656 638

## Description

The invention concerns a method for cleaving semiconductor wafers, or segments thereof, and for coating the cleaved facets. The method is particularly suited for the fabrication of semiconductor laser diodes since it allows mirror facet cleaving and in-situ passivation in a vacuum environment to achieve long life-time, high-power devices. The present invention also relates to an apparatus suitable for carrying out the described method.

Semiconductor laser diodes have found applications in a wide variety of information handling systems, partly because of their compact size and partly because their technology is compatible with that of the associated circuitry and other electro-optical elements. They are being used in areas such as data communication, optical storage and optical beam printing. Currently, most lasers consist of III/V compound materials. Depending on the required laser beam wavelength, AlGaAs- and InP-system devices have found extensive usage.

As of today, most commonly used are laser structures where the mirrors terminating the laser cavity are obtained by cleaving. Normally. a wafer carrying a large number of epitaxially grown laser structures is cleaved into laser bars, the cleaved facets at both sides thereof determining the length of the cavity of the devices on the bar.

The cleaving process is normally started in that the wafer surface is diamond scratched, or scribed, to determine the crystallographic planes where cleaving is to take place. The scratch serves as a microcrack from where, upon application of a bending moment, controlled fracturing proceeds to complete the cleave. The required torque or shearing force is applied using wedges, "knives" or other small-radius tools.

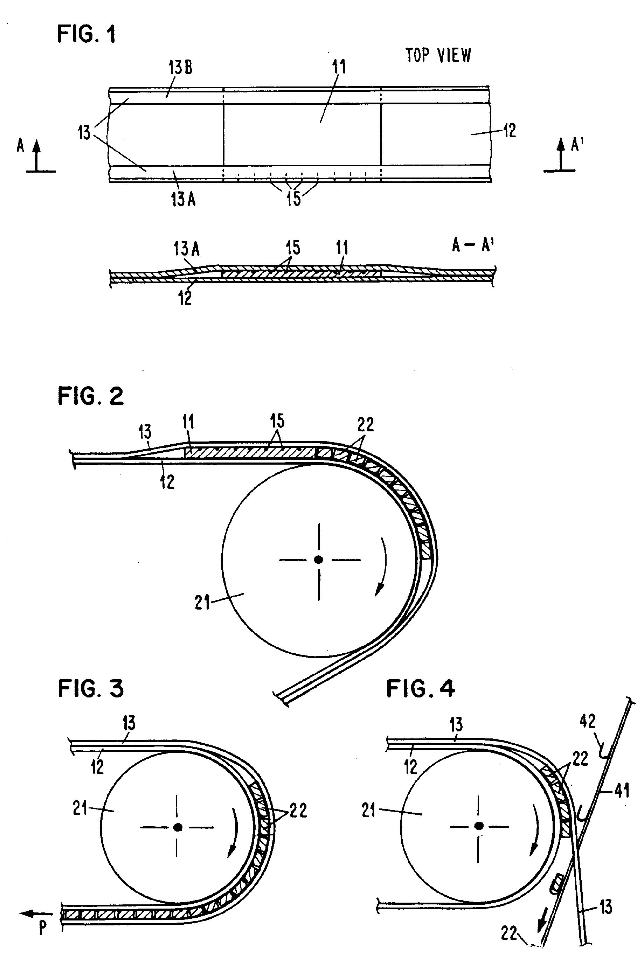

Numerous processes and devices for laser cleaving have been suggested and pursued in the past. Some of these approaches, illustrating the development of the cleaving technique and representing the state of the art, are described in the following references :
- German published patent application 1,427,772 describes a process for breaking a scribed semiconductor wafer into individual bars. The wafer, held between foils, is placed on a soft-surface support. Cleaving is achieved in that a hard, small-radius roller is pressed against and moved across the wafer thereby applying the required torque.
- U.S. Patent 3,396,452 briefly describes, in the introduction and with reference to Fig.3, a then conventional cleaving tool. It comprises a convex base member having a curvature suitable to the dimensions of the bars into which the wafer, sandwiched between foils, is to be broken. Through a complementary concave member, pressed against the wafer which rests on the convex surface, a non-uniform bending moment is applied. The invention disclosed in the U.S. Patent relates to a method and apparatus where a scribed semiconductor wafer is advanced and subjected to pressure between a pair of opposing small-radius rollers of different resiliencies. The softer resiliency roller, being contiguous with the scribed wafer face, causes the wafer to break at the scribe lines.
- Article "Process for Batch Cleaving GaAs and Similar Materials", published in IBM's Technical Disclosure Bulletin, Vol.23, No. 10, March 1981, pp 4749-4750, provides a summary of the main requirements for controlled, non-damaging cleaving processes. It does not refer to any specific details of the process or the apparatus used.
- European Patent Application 88.810 694.5, filed on October 10, 1988, describes a method and apparatus for cleaving a semiconductor water. The wafer is sandwiched between two elastic foils : a rather soft lower foil with an adhesive surface to which the wafer "sticks", and a stronger cover foil. The foils are then fixed and stretched, the wafer, however, preventing the stretching, at least partly, within that part of the lower foil to which it adheres. By passing a small-radius roller underneath the foils, the wafer is lifted and cleaved. The obtained bars still adhere to the now completely stretched lower foil, separated from each other by a distance that is sufficient to avoid mutual damage of neighbouring cleaved mirror surfaces.
- U.S. Patent 4,195,758 discloses an apparatus for cleaving ceramic members being referred to as snapstrates. This apparatus is characterized in that the snapstrates are advanced between two transport bands and forced around the curved surfaces of three rollers. Deep kerfs scribed into one of the snapstrates' surfaces, either facing upward or downward, cause the fracture of the ceramic member either when an upward force or when a downward force is applied.
- U.S. Patent 4,656,638 discloses laser diodes being passivated by passivation layers applied to their air-cleaved facets. These passivation layers typically consist of Al, Si, Ta, V, Sb, Mn, Cr and Ti.

The methods and apparatus described in these references, as well as all others known to the applicant, still don't meet all the major requirements of a high-quality batch cleave process which include :
- gentle, stress-free fracturing along the desired crystallographic plane,
- avoidance of damage to device structures due to external forces applied thereto during cleaving,
- minimum handling of both the wafer and the resulting bars.
- separation of the bars upon cleaving to prevent mechanical damage of neighbouring facets,
- obtaining uncontaminated facets followed by immediate application of a uniform passivation coating, and
- applicability in a vacuum system.

As a consequence, major problems were still observed with regard to the life-time and output power characteristics of the cleaved devices.

However, recently substantial progress was made in this regard. It has been found that cleaving in vacuum, immediately followed by in-situ coating the then contamination-free mirror facets with a passivation layer, allows the fabrication of extremely stable AlGaAs laser diodes. With this method, devices with very low degradation rates and high-power output performance have been obtained.

Such process is disclosed in European Patent application 89.810 668.7, filed on September 7, 1989. But the embodiment described in the specification, suitable for single bar or device processing, is not directly applicable to volume laser device manufacturing. It does not address or solve the additional problems encountered with batch processing such as the strict requirement of separating the bars right after cleaving in order to avoid facet damage.

It is thus a main object of the present invention to provide a method and apparatus for semiconductor wafer cleaving that is suitable for large scale or batch mode laser diode fabrication.

Another object is to provide a method and apparatus allowing the cleaving of laser wafers in a high vacuum environment followed by in-situ passivation of the cleaved facets to avoid any facet contamination.

A further object is to provide a method and apparatus for cleaving semiconductor wafers to form individual laser bars, each having cleaved facets, and to immediately separate neighbouring bars from each other, sufficient to avoid mutual damage, and to allow selective coating of the facets.

The invention as claimed is intended to meet the above defined objectives and to remedy the deficiencies of known laser mirror cleave and passivation coating techniques. The inventive method according to claim 1 and apparatus according to claim 11 solve the problems hitherto encountered in that the wafer (or a wafer segment) to be processed is, first, scribed to define the planes where the wafer is to be fractured to form individual bars, and then placed between a pair of flexible transport bands and guided around a curved, large radius surface thereby applying a bending moment. With a moment of sufficient magnitude, individual bars are broken off the wafer as this is advanced, each bar having front- and rear-end facets. On cleaving, each bar, while still pressed against the curved surface, is automatically separated whereby mutual damage of facets of neighbouring bars is avoided. For further handling, e.g., for the transport of the bars to an evaporation station for in-situ passivation, provisions are made to keep the bars separated.

In one embodiment, the separation of the bars is being maintained in that the transport bands are made of a stretchable material. The bands, with the cleaved bars held inbetween, are longitudinally stretched as soon as they come off the curved surface. In another embodiment, the transport bands part after cleaving thus releasing the bars one after the other. The bars are gripped and individually transferred to a magazine where they are kept separated until further processing in the evaporation station.

For laser devices with extreme power capabilities and high life-time requirements, cleaving and the subsequent passivation coating are carried out in-situ in a vacuum system thereby preventing facet contamination prior to applying the passivation layer.

A main advantage offered by the invention is that it allows semiconductor wafer batch processing in a vacuum system. Wafer cleaving and the subsequent passivation of the facets can be done in-situ without breaking the vacuum. Using a proper passivation coating, e.g., a thin layer of Si, prevents any interaction with the facet surface whereby mirror degradation during laser operation is drastically reduced. Long life-time, high-power lasers can be achieved.

The invention is described in detail below with reference to drawings which illustrate specific embodiments of the invention and in which
- **Fig. 1**: illustrates how, in the described embodiments, a scribed wafer is held between lower and upper transport bands;
- **Fig. 2**: is a schematic side view of a cleave roller over which a wafer, sandwiched between lower and upper transport bands, is bent and cleaved to form bars which remain separated while still pressed against the roller;
- **Fig. 3**: is a schematic side view of a cleave roller illustrating how the cleaved bars are kept separated from one another by using stretchable transport bands;
- **Fig. 4**: is a schematic side view of a cleave roller illustrating how the cleaved bars are kept separated from one another by releasing them from inbetween the transport bands;
- **Fig. 5**: is a schematic representation of a batch cleave apparatus designed in accordance with the present invention;
- **Fig.6 A&B**: show schematic sketches used to explain design conditions of the inventive batch cleave apparatus.

It has been shown that, by cleaving and coating the mirrors of a semiconductor laser in ultra-high-vacuum (UHV), a greatly increased power output, threshold for catastrophic optical damage and operating life are obtained in comparison with mirrors which are cleaved in air. To be competitive in the manufacture of such lasers it is necessary to devise an efficient technique to cleave, separate, transport and coat the laser bars to obtain a high throughput and a high yield of perfect lasers. The present invention is designed to fulfil these requirements.

Before describing an embodiment of the invention in greater detail, the underlying basic concepts will be briefly outlined with the aid of figures 1 to 4.

Initially, the wafer to be cleaved is diamond-scratched to predetermine the crystallographic planes where fracturing is to take place and, thereby, the length of the laser bars after cleaving which, in turn, corresponds to the laser cavity length.

Fig.1 shows, how, in the inventive process, a wafer 11 to be cleaved at planes defined by scribe lines (indicated by fine marks 15) can be embedded between two flexible transport bands, a lower band 12 and an upper band 13. The bands are pressed together by means not shown in this drawing to tightly hold the wafer during processing in the position as initially inserted : the scribe lines 15 facing the upper band and oriented perpendicular to the longitudinal direction of the transport bands. In the illustrated example. the upper band consists of two narrow stripes 13A and 138 that are arranged over sections of the wafer 11 that do not comprise fragile device or metallization structures which would be sensitive to pressure applied by the stripes during the cleaving process. Such critical structures are located in the "window" inbetween the stripes and are thus not subjected to stress whereby damage is avoided. Use of a single narrow stripe, 13A or 13B, can provide even better results in that it prevents any stress in the wafer material during fracturing. This results in a "gentle" cleave and thus in high quality facet surfaces.

Fig.2 illustrates the principle applied in the actual cleaving process. The wafer 11, sandwiched between the flexible transport bands 12 and 13, is advanced to the cleaving station comprising a body 21 having a curved, large radius surface, the radius being in the order of 5 to 25 mm. Preferably, the body is in the form of a roller, rotatable about its axis. The bands 12 and 13, with the wafer 11 inbetween, are pulled around the curved surface, the wafer being tied down by the upper band 13. Thus, a bending force is applied to the wafer, breaking off laser bars 22 one after the other in the positions determined by the scribe lines 15. On cleaving, the upper parts of the cleaved facets are separated at a distance given by the bending radius. This automatically prevents any mutual mechanical contact between the very fragile and critical facet surfaces whereby facet damage leading to device performance degradation is avoided.

Next, the cleaved bars need to be transported to the evaporation station for the deposition of the passivation coating. It is most essential that, during the transport, the bars remain separated. Two possible ways of accomplishing this are schematically illustrated in Fig. 3 and 4.

In the embodiment of Fig.3, stretchable bands 12 and 13 are used for the transport. On cleaving, the bands are stretched by a force P pulling the bands around the curved surface, in the example the roller 21, whereby the individual laser bars remain separated as shown. If the bars are to be coated while still held between the two transport bands 12 and 13, the upper band must be designed so as to provide a window sufficient to expose the sections of the facets onto which a passivation layer is to be evaporated. Suitable for this purpose are bands 13 consisting of one or two narrow stripes as shown in Fig.1.

Another embodiment of an arrangement for bar separation is schematically illustrated in Fig.4. Here, the laser bars are removed from the transport bands 12 and 13 after cleaving, to be placed in a holder or magazine used to transport the batch of bars to the evaporation station. As shown in the drawing, the transport bands are initially pressed together, holding the wafer until cleaving has taken place. Upon cleaving, the upper band 13 is guided away from the lower band 12 thereby successively releasing the cleaved and separated bars 22. The bars are then gripped or caught, one possibility being indicated by the transport belt 41 having hooks 42 for carrying the bars to a magazine (not shown in Fig.4) where separation of the individual bars is maintained.

For in-situ coating of the cleaved facets in an UHV chamber, care must be taken in chosing the materials and elements used for the cleave apparatus and the transport bands since they have to be UHV-compatible.

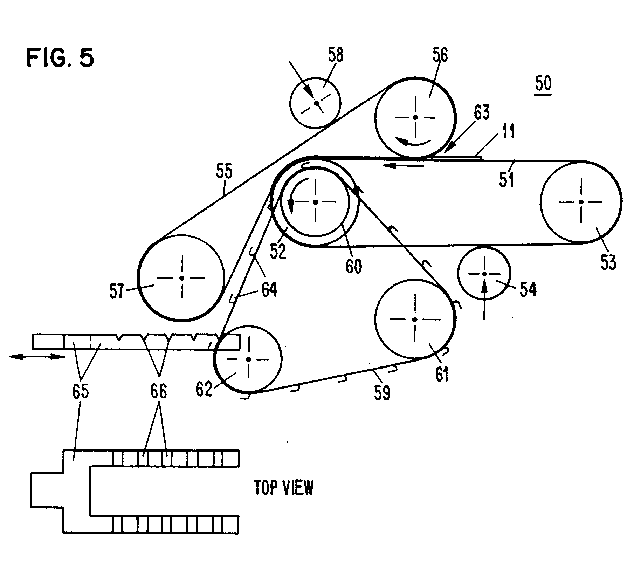

Fig.5 is a schematic side view of a cleaving apparatus designed in accordance with the concepts of the present invention that have been outlined above with reference to Fig.1 to 4. It is applicable in an UHV system.

The illustrated mechanism is suitable for performing the wafer cleaving and the bar separating operation, and also allows for the subsequent transporting of the cleaved bars to an evaporation station for in-situ coating of a passivation layer. Even if the apparatus is operated semi-manually in that, e.g., wafer insertion and driving the transport band is not fully automated, it provides for high throughput and requires minimal handling.

In the apparatus shown in Fig.5, the lower transport band 51 is moved counter-clockwise around rollers 52 and 53, roller 52 being driven via coupling means from outside the UHV chamber. A constant tension on the band is maintained by means of a roll 54 pressed against the band and/or by using a spring-loaded roller 53.

The upper transport band 55 runs around rollers 56 and 57. As illustrated it is pressed against band 51 where this is guided around roller 52. The friction between the two bands, 51 and 55, drives the latter in a clockwise direction. The upper band 55 is tensioned by a pressure roll 58 and/or by using a spring-loaded roller 56 or 57.

The wafer 11 to be cleaved is inserted at 63 between the lower and the upper transport bands. Accurate positioning is essential for a clean, gentle wafer fracturing operation. The wafer, sandwiched between bands 51 and 55, is then transported towards roller 52 and constrained to move and bend over the roller thereby imparting the necessary bending moment to cleave the wafer into bars as the transport bands proceed. As previously explained with reference to Fig.2, the individual bars are separated on cleaving at least to the extent that facets of neighbouring bars cannot damage each other.

In the described embodiment, transport bands 51 and 55 separate after cleaving has taken place. This causes the individual bars to be successively released. They need to be gripped as has been explained above in connection with Fig.4. In the embodiment of Fig.5, a transport belt 59 having shaped metal projections, namely the hooks designated 64, is used for this purpose. Belt 59 is moved at a higher speed than the transport bands 51 and 55 to warrant that there is always a hook in place as a bar is released. It is driven around rollers 61, 62 and 60 in a counter-clockwise direction, roller 60 being arranged on the same axis as roller 52 but it has a different diameter and rotates independently.

Having cleaved, separated and gripped the bars, it is then a relatively simple matter to collect, arrange and transport them for coating of the facets. One possibility is schematically illustrated in Fig.5. A U-shaped holder 65, having arms with grooves 66 as shown, spans belt 59 at the position indicated in the drawing. As a bar, supported by one of the hooks 64, moves downward, the ends of the bar are guided into one of the tapered grooves 66. Holder 65 is then advanced to the left, so that a vacant groove is ready to receive the next bar. The holder acts as a magazine for e.g. all bars into which a wafer 11 is broken. When all grooves have been filled, the bars are secured in their positions (by means not shown in the drawing). Thereupon, the magazine 65 can be used to transport the batch of bars to the evaporation station of the vacuum system for the protective coating of the facets.

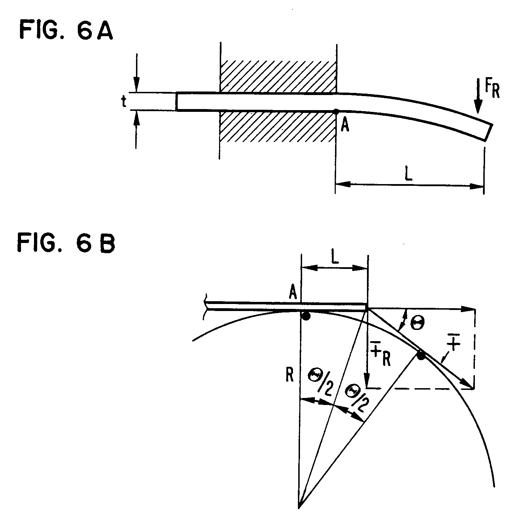

Referring now to Fig. 6A and 6B, some of the essential requirements and conditions that need to be taken into account when designing and operating a cleave apparatus as shown in Fig.5, are outlined.

The natural cleavage planes of III/V compound semiconductors such as GaAs are those conventionally denominated {110}. For a laser it is important that the resultant cleaved mirror surface be "perfect" in the sense of having no steps or other imperfections in the vicinity of the emitting facet region. To produce such a surface requires not only that the scribe lines used to define the cleaving plane be properly scratched at the edge of the wafer but also that a uniform tensile stress perpendicular to the required direction of propagation of the cleave is applied. This, in turn, requires proper positioning of the wafer with respect to the applied bending force by accurately placing and tightly fixing it between the transport bands, avoiding any restraints on the wafer allowing it to fracture at the desired plane, and the use of a bending force which, as will be explained below, must not be too different from an ideal value.

For the simple cantilever geometry of Fig.6A, elementary considerations show that the strain S at the fulcrum A, caused by a bending moment ${\text{M = F}}_{\text{R}} \text{x L}$ , is given by$\text{S=} \frac{\text{6}}{\text{Ewt²}} \text{· M}$
where w is the width and t the thickness of the sample to be broken, and E is Young's modulus for the material.

When cleavage takes place at a critical strain S_{c}, the bending moment at which the sample will fracture is obtained as${\text{M}}_{\text{c}} \text{=} \frac{\text{1}}{\text{6}} {\text{· Ewt² · S}}_{\text{c}} \text{=F} {\text{}}_{{\text{R}}_{\text{c}}} \text{· L}$

For cleaving laser wafers over a roller as in the system illustrated in Fig.5, and when applying the bending moment via a flexible band to which a pulling force F is applied as sketched in Fig.6B, we obtain for the cleaving force F_{R} applied perpendicular to the wafer${\text{F}}_{\text{R}} \text{=F · sinΘ = F · 2} \frac{\text{L}}{\text{R}}$
since, for small angles Θ,$\text{sinΘ ≈} \frac{\text{2L}}{\sqrt{{\text{R² + L}}^{\text{2'}}}} \text{≈ 2} \frac{\text{L}}{\text{R}}$

From equations (2) and (3) one obtains the force F_{c} applied to the upper transport band that is required to obtain the necessary cleave moment M_{c} when the wafer is advanced since the last cleavage by the distance L, i.e., when the next scribe line is at point A :${\text{F}}_{\text{c}} \text{=F} {\text{}}_{{\text{R}}_{\text{c}}} \text{·} \frac{\text{R}}{\text{2L}} {\text{=M}}_{\text{c}} \text{·} \frac{\text{R}}{\text{2L²}}$
or, for a wafer of given thickness and width${\text{F}}_{\text{c}} \text{=const. ·} \frac{\text{R}}{\text{L²}}$

It is to be noted that the critical moment M_{c} that is required to cleave a wafer of a given material and cross-section, must be applied when the next scribe line arrives at point A, i.e., when L equals the length of the laser bar to be obtained. Any substantial deviation will have a negative effect on the cleave process, resulting in lower quality mirrors, or may even prevent that the cleave is effected at the plane defined by the scribe line.

If the applied force F is smaller than F_{c}, ${\text{M}}_{\text{c}} {\text{= F}}_{\text{R}} \text{x L}$ is reached only after the wafer is advanced by a distance greater than L. As a result, the water will not break at the desired plane as defined by the scribe line, but will uncontrollably and depending on the circumstances break inbetween scribe lines or at the subsequent scribe line, making the bar 2 L long.

Problems also arise in case F is larger than F_{c}, i.e., M_{c} is reached before the scribe line has arrived at point A. Again, it is uncertain what will happen. The water may cleave at about point A resulting in an unsatisfactory facet and a bar that is too short, or it may break at the scribe line under rather uncontrolled conditions. The problem will get worse with subsequent bars unless the pulling force F is properly corrected.

An exact calculation of F(c) is virtually impossible since it depends on factors, such as the friction between the transport bands and the torque required to break the scratched water, that cannot be determined with sufficient accuracy. However, making adjustments to the tension applied to the transport bands quickly leads to a then rather uncritical operation of the cleave apparatus. Before using wafers of a different thickness or width, or when the bar length to be obtained is changed, a new adjustment is required.

A further important feature to be considered is the radius R of the roller over which the wafer is cleaved.

From equation (5) it is apparent that the required force F_{c} is proportional to the radius R of the cleave roller because the effective force F_{R}, perpendicular to the water, becomes, for a given force F, smaller with increasing radius R. In order to avoid the necessity of using very large forces, requiring excessive friction between the transport bands, the roller should not be too big.

On the other hand, severe operational problems arise in case rollers of a rather small radius are used. One of the difficulties is seen in the fact that the wafer, inserted inbetween the transport bands, is kept in place and moved against any resistances merely by the friction between the wafer and the transport bands. When the wafer, before cleaving, is moved tangentially along and over the roller, a substantial resistance is built up and, in addition, the friction is reduced because the wafer is, in extreme situations, lifted from the lower band. As a result, the forward force is insufficient to overcome the resistance.

In practice it has been observed that, for proper operation of the cleaving system, the relation L : R between the laser bar length and the roller radius should be between 1/10 and 1/50. For a bar length L of 0.5 mm, this means that the radius R should be$\text{5mm < R < 25mm}$

In other words, any sharp wedges or "knives", and even small radius rollers (R = 1 to 2 mm) that have in the past been used for various cleaving techniques, are not suited for the present invention.

The inventive method and apparatus herein described are designed for use in batch-fabricating semiconductor lasers. To illustrate the number of bars and laser chips that can be handled by a single vacuum chamber run it is assumed that the wafer length be 20 mm, the width 25 mm, of which 5 mm are used to firmly grip the ends of the bars as described above. For lasers of 0.5 mm length, this yields 40 bars which, for a chip or laser width of 0.25 mm, results in a total of 40 x 80 = 3,200 lasers.

In order to improve the efficiency of the process, particularly when carried out in a vacuum chamber, the system can be completed by adding (1) an input magazine arrangement for supporting and inserting a number of to-be-cleaved wafers, and (2) load locks for loading wafers and for withdrawing the coated bars. When loading the system with, e.g., 10 wafers, the throughput of the vacuum system could thus be increased to 32,000 lasers per run.

## Claims

1. A method for batch cleaving of wafers comprising the steps of scribing one of the wafer surfaces with parallel scribe lines (15) to define the planes where the wafer (11) is to be cleaved, placing the wafer (11) between flexible lower (12) and upper (13) transport bands, the wafer being oriented with the scribe lines (15) perpendicular to the longitudinal direction of the transport bands, applying a bending force suitable for cleaving the wafer (11) at a scribe line (15) to cleave the wafer along said scribe lines by moving the transport bands (12, 13) with the wafer (11) held inbetween around a body (21) having a curved, large radius surface,
said method being characterized in that:
- said wafers are semiconductor wafers carrying laser diodes, the scribe lines being parallel to the crystallographic planes of the substrate,
- the distance L between neighboring scribe lines defines the length of a laser's cavity,
- the cleaved facets serve as mirror facets of said lasers.
- said wafers are oriented with the scribe lines (15) facing the upper band (13) of the transport bands prior to being cleaved,
- the relation L : R between the laser bar length L and the radius of said curved surface is between 1/10 and 1/50,
- said cleaving and coating processes are carried out "in-situ", i.e., in the same environment
- said laser bars (22) are separated after cleavage so as to prevent mutual facet damage by means of a defined tension in said transport bands and the curvature of said large radius surface,
- said laser bars (22) are transported, while keeping neighboring bars separated, to an evaporation station, and
- a coating is applied to the facets.

2. A method as in claim 1, wherein said body having a curved surface is a roller (21) rotatable around its axis.

3. A method as in claim 1, wherein the coating applied at the evaporation station is a passivation layer.

4. A method as in claim 3, wherein said coated passivation layer consists of silicon.

5. A method as in claim 1, wherein said environment is an ultra-high vacuum.

6. A method as in claim 1, wherein the width of the lower transport band (12) is at least as wide as the wafer (11), whereas the upper transport band (13) consists of one or two bands each substantially narrower than the wafer, these narrow bands being in contact with regions where the wafer structure is not sensitive to external pressure applied during the cleave operation.

7. A method as in claim 1, wherein the flexible transport bands (12, 13) are made of a stretchable material.

8. A method as in claim 2, wherein the lower and the upper transport bands (51; 55) are individually guided around rollers (52 and 53; 56 and 57) so as to allow inserting and holding the wafer (11) until cleavage and to automatically release the cleaved bars thereafter.

9. A method as in claim 8, wherein one of said transport bands (51) is advanced by driving one of the associated rollers (52) whereas the other transport band (56) is advanced due to friction between the two transport bands (51, 56).

10. A method as in claim 8, wherein a separate transport belt (41) with hooks (42) is provided and used to catch the released. cleaved bars (22) and to transport them to a magazine where the bars are stored while remaining separated from each other.

11. An apparatus (50) for batch cleaving of wafers along parallel scribe lines, said wafers carrying laser diodes and said scribe lines being parallel to the crystallographic planes of the substrate, said apparatus comprising lower (51) and upper (56) transport bands that are tightly pressed against each other over part of their length to firmly hold the substrate to be cleaved therebetween, with the scribe lines perpendicular to the longitudinal direction of the transport bands, drive means for moving said transport bands and therewith advancing said substrate around a body (52) having a curved. large radius surface, to apply a bending force suitable for cleaving the wafer (11) at each scribe line (15), said apparatus being characterized in that
∘ the radius R of said curved surface is such that the relation L : R between the laser bar length L, i.e. the distance between two neighboring scribe lines, and the radius R of said curved surface is between 1/10 and 1/50,
∘ said transport bands are tensioned such that the laser bars, while still being forced against the curved surface, are automatically positioned, by means of the defined tension in said transport bands and the curvature of said large radius surface, so that the cleaved facets of neighboring laser bars are separated to prevent mutual damage, and the apparatus comprising
∘ transport means which are employed for further advancing said laser bars to an evaporation station where a coating is applied to the facets, while keeping neighboring bars separated.

12. An apparatus as in claim 11, wherein said body having a curved surface is a roller (52).

13. An apparatus as in claim 11, wherein the width of the lower transport band (51) is at least as wide as the wafer (11), whereas the upper transport band (56) consists of one or two bands (13A, 13B) each substantially narrower than the wafer.

14. An apparatus as in claim 11, wherein the flexible transport bands are made of a stretchable material.

15. An apparatus as in claim 11, wherein the lower and the upper transport bands (51, 56) are guided around rollers (52 and 53: 56 and 57) so as to allow inserting and holding the wafer until cleavage and to automatically release the cleaved bars thereafter.

16. An apparatus as in claim 15, wherein one of said transport bands (51) is advanced by means driving one of the associated rollers (52) whereas the other transport band (56) is advanced due to the friction between the two transport bands (51, 56).

17. An apparatus as in claim 15, wherein a separate transport belt (41) with hooks (42) is provided for catching said released cleaved bars (22) and for transporting them to a magazine (65) where the bars are stored while remaining separated from each other.

## Patentansprüche

1. Eine Methode zum Spalten von Platten in Serie, die folgende Schritte umfaßt: Anreißen einer Plattenoberfläche mit parallelen Anrißlinien (15) zum Festlegen der Ebenen, an denen die Platte (11) gespalten wird, Anordnen der Platte (11) zwischen flexiblen unteren (12) und oberen (13) Transportbändern, wobei die Platte mit den Anrißlinien (15) so ausgerichtet wird, daß die Anrißlinien senkrecht zur Längsrichtung der Transportbänder liegen, Aufbringen einer Biegekraft, die zum Spalten der Platte (11) an einer Anrißlinie (15) geeignet ist, um die Platte entlang der genannten Anrißlinien zu spalten, indem die Transportbänder (12, 13) mit der dazwischenliegenden Platte (11) um einen Körper (21) mit einer gekrümmten Oberfläche und großem Radius herumgeführt wird,
wobei die genannte Methode dadurch gekennzeichnet ist, daß:
- die genannten Platten Halbleiterplatten sind, auf denen sich Laserdioden befinden, und die Anrißlinien parallel zu den kristallographischen Ebenen des Substrats liegen,
- die Distanz L zwischen benachbarten Anrißlinien die Länge eines Laserresonators festlegt,
- die gespaltenen Facetten als Spiegelfacetten des genannten Lasers dienen,
- die genannten Platten vor dem Spalten so ausgerichtet sind, daß die Anrißlinien (15) zum oberen Band (13) der beiden Transportbänder liegen,
- das Verhältnis L : R zwischen der Länge L des Laserstäbchens und dem Radius der genannten gekrümmten Oberfläche zwischen 1/10 und 1/50 liegt,
- die genannten Spalt- und Beschichtungsverfahren "an Ort und Stelle", das heißt, in derselben Umgebung, ausgeführt werden,
- die genannten Laserstäbchen (22) nach dem Spalten voneinander getrennt werden, so daß ein gegenseitiges Beschädigen der Facetten verhindert wird, und zwar mit Hilfe einer festgelegten Zugspannung in den genannten Transportbändern und der Krümmung der genannten Fläche mit großem Radius,
- die genannten Laserstäbchen (22) zu einer Bedampfungsstation transportiert werden, wobei gleichzeitig benachbarte Stäbchen voneinander getrennt gehalten werden, und
- auf die Facetten eine Beschichtung aufgebracht wird.

2. Eine Methode nach Anspruch 1, in der der genannte Körper mit gekrümmter Oberfläche eine um ihre Achse drehbare Walze (21) ist.

3. Eine Methode nach Anspruch 1, in der die in der Bedampfungsstation aufgebrachte Beschichtung eine Passivierungsschicht ist.

4. Eine Methode nach Anspruch 3, in der die genannte aufgetragene Passivierungsschicht aus Silizium besteht.

5. Eine Methode nach Anspruch 1, in der die genannte Umgebung ein Ultrahochvakuum ist.

6. Eine Methode nach Anspruch 1, in der die Breite des unteren Transportbandes (12) mindestens der Breite der Platte (11) entspricht, während das obere Transportband (13) aus einem oder zwei Bändern besteht, die jeweils wesentlich schmäler als die Platte sind, wobei diese schmäleren Bänder Bereiche kontaktieren, in denen die Plattenstruktur während des Spaltvorganges gegenüber dem von außen aufgebrachten Druck nicht empfindlich ist.

7. Eine Methode nach Anspruch 1, in der die flexiblen Transportbänder (12, 13) aus einem dehnbaren Material gefertigt sind.

8. Eine Methode nach Anspruch 2, in der das untere und das obere Transportband (51; 55) einzeln um Walzen (52 und 53; 56 und 57) herumgeführt werden, so daß die Platte (11) eingeführt werden und bis zur Spaltung und zur automatischen Freigabe der gespaltenen Stäbchen im Anschluß an die Spaltung gehalten werden kann.

9. Eine Methode nach Anspruch 8, in der eines der genannten Transportbänder (51) vorwärts transportiert wird, indem eine der zugeordneten Walzen (52) angetrieben wird, während das andere Transportband (56) aufgrund der Reibung zwischen den beiden Transportbändern (51, 56) nach vorne geführt wird.

10. Eine Methode nach Anspruch 8, in der ein separates Transportband (41) mit Haken (42) zum Auffangen der freigegebenen gespaltenen Stäbchen (22) und zum Transport der Stäbchen zu einem Magazin dient, wo die Stäbchen gelagert werden, während sie gleichzeitig voneinander getrennt gehalten werden.

11. Eine Vorrichtung (50) zur serienmäßigen Spaltung von Platten entlang parallel verlaufender Anrißlinien, wobei die genannten Platten Laserdioden tragen, und die genannten Anrißlinien parallel zu den kristallographischen Ebenen des Substrats verlaufen, wobei die genannte Vorrichtung untere (51) und obere (56) Transportbänder aufweist, die auf einem Teil ihrer Länge fest gegeneinander gepreßt werden, um das dazwischenliegende und zu spaltende Substrat festzuhalten, wobei die Anrißlinien senkrecht zur Längsrichtung der Transportbänder liegen, Antriebsmittel zur Bewegung der genannten Transportbänder und damit zum Vorschub des genannten Substrats, um einen Körper (52) mit einer gekrümmten Oberfläche mit großem Radius, um eine Biegekraft aufzubringen, die zum Spalten der Platte (11) an jeder Anrißlinie (15) geeignet ist, wobei die genannte Vorrichtung dadurch gekennzeichnet ist, daß:
- der Radius R der genannten gekrümmten Oberfläche so bemessen ist, daß das Verhältnis L : R zwischen der Länge L des Laserstäbchens, das heißt die Distanz zwischen zwei benachbarten Anrißlinien, und der Radius R der genannten gekrümmten Oberfläche zwischen 1/10 und 1/50 liegt,
- die genannten Transportbänder in der Weise unter Zug gesetzt werden, daß die Laserstäbchen, noch während sie gegen die gekrümmte Oberfläche gedrückt werden, automatisch positioniert werden, und zwar mit Hilfe der festgelegten Zugspannung in den genannten Transportbändern und der Krümmung der genannten Oberfläche mit großem Radius, so daß die gespaltenen Facetten benachbarter Laserstäbchen voneinander getrennt werden, um eine gegenseitige Beschädigung zu vermeiden, und die Vorrichtung desweiteren folgendes umfaßt:
- Transportmittel, welche für den Weitertransport der genannten Laserstäbchen zu einer Bedampfungsstation verwendet werden, wo auf die Facetten eine Beschichtung aufgebracht wird, während benachbarte Stäbchen voneinander getrennt gehalten werden.

12. Eine Vorrichtung nach Anspruch 11, in der der genannte, eine gekrümmte Oberfläche aufweisende Körper, eine Walze (52) ist.

13. Eine Vorrichtung nach Anspruch 11, in der die Breite des unteren Transportbandes (51) mindestens die Breite der Platte (11) hat, während das obere Transportband (56) aus einem oder zwei Bändern (13A, 13B) besteht, die beide wesentlich schmäler als die Platte sind.

14. Eine Vorrichtung nach Anspruch 11, in der die flexiblen Transportbänder aus dehnbarem Material gefertigt sind.

15. Eine Vorrichtung nach Anspruch 11, in der das untere und das obere Transportband (51, 56) um Walzen (52 und 53; 56 und 57) herumgeführt werden, so daß ein Einführen und Halten der Platte bis zur Spaltung und automatischen Freigabe der gespaltenen Stäbchen möglich ist.

16. Eine Vorrichtung nach Anspruch 15, in der eines der genannten Transportbänder (51) durch Mittel vorwärts transportiert wird, die eine der zugeordneten Walzen (52) antreiben, während das andere Transportband (56) aufgrund der Reibung zwischen den beiden Transportbändern (51, 56) vorwärts transportiert wird.

17. Eine Vorrichtung nach Anspruch 15, in der ein separates Transportband (41) mit Haken (42) zum Auffangen der genannten freigegebenen gespaltenen Stäbchen (22) und zum Transport dieser Stäbchen in ein Magazin (65) dient, wo die Stäbchen gelagert werden, während sie gleichzeitig voneinander getrennt gehalten werden.

## Revendications

1. Un procédé de clivage de tranches par lots, comprenant les étapes de traçage sur l'une des surfaces des tranches, de lignes de traçage paralléles (15) pour définir les plans où la tranche (11) doit être clivée, de placement de la tranche (11) entre des bandes de transport souples inférieure (12) et supérieure (13), la tranche étant orientée de façon que les lignes de traçage (15) soient perpendiculaires à l'axe longitudinal des bandes de transport, d'application d'une force de déformation appropriée pour cliver la tranche (11) à une ligne de traçage (15) et la fendre le long desdites lignes de traçage en entraînant les bandes de transport (12, 13) avec la tranche (11) maintenue entre elles, autour d'un corps (21) présentant une surface circulaire de rayon important,
ledit procédé étant caractérisé en ce que:
- lesdites tranches sont des tranches' de semiconducteur portant des diodes à laser, les lignes de traçage étant parallèles aux plans cristallographiques du substrat,
- la distance L entre des lignes de traçage voisines, définit la longueur d'une cavité de laser,
- les facettes clivées servent de facettes de miroir auxdits lasers,
- lesdites tranches sont orientées avec les lignes de traçage (15) disposées face à la bande supérieure (13) des bandes de transport avant d'être clivées,
- la relation L : R entre la longueur de barre laser L et le rayon de ladite surface incurvée est comprise entre 1/10 et 1/50,
- lesdits procédés de clivage et de revêtement sont exécutés "in situ", c'est à dire dans le même environnement,
- lesdites barres de laser (22) sont séparées après clivage de maniére à éviter l'endommagement mutuel des facettes au moyen d'une tension définie desdites bandes de transport et de la courbure de ladite surface de rayon important,
- lesdites barres de laser (22) sont transportées tout en maintenant les barres voisines séparées, à une station d'évaporation, et
- un revêtement est appliqué aux facettes.

2. Un procédé selon la revendication 1 dans lequel ledit corps présentant une surface incurvée, est un rouleau (21) tournant autour de son axe.

3. Un procédé selon la revendication 1 dans lequel le revêtement appliqué à la station d'évaporation est une couche de passivation.

4. Un procédé selon la revendication 3 dans lequel ladite couche de passivation revêtue est composée de silicium.

5. Un procédé selon la revendication 1 dans lequel ledit environnement est un vide très poussé.

6. Un procédé selon la revendication 1 dans lequel la largeur de la bande de transport inférieure (12) est au moins aussi large que la tranche (11), tandis que la bande de transport supérieure (13) est composée d'une ou de deux bandes, chacune d'elles étant substantiellement plus étroite que la tranche, ces bandes étroites étant en contact avec des régions où la structure de la tranche n'est pas sensible à la pression extérieure appliquée pendant l'opération de clivage.

7. Un procédé selon la revendication 1 dans lequel les bandes de transport flexibles (12, 13) sont composées d'un matériau élastique.

8. Un procédé selon la revendication 2 dans lequel les bandes de transport inférieure et supérieure (51, 55) sont individuellement guidées autour des rouleaux (52 et 53, 56 et 57) de façon à permettre l'insertion et le maintien de la tranche (11) jusqu'au clivage et ensuite le relâchement automatique des barres clivées.

9. Un procédé selon la revendication 8 dans lequel l'une desdites bandes de transport (51) est avancée par l'entraînement de l'un des rouleaux associés (52) tandis que l'autre bande de transport (56) est avancée en raison du frottement entre les deux bandes de transport (51, 56).

10. Un procédé selon la revendication 8 dans lequel une courroie de transport séparée (41) avec des crochets (42) est prévue et utilisée pour saisir les barres clivées et relâchées (22) et les entraîner dans un magasin où elles sont stockées tout en restant séparées les unes des autres.

11. Un dispositif (50) pour le clivage de tranches par lots le long de lignes de traçage paralléles, lesdites tranches portant des diodes à laser et lesdites lignes de traçage étant parallèles aux plans cristallographiques du substrat, ledit dispositif comprenant des bandes de transport inférieure (51) et supérieure (56) qui sont fortement serrées l'une contre l'autre sur une partie de leur longueur afin de retenir fermement entre elles le substrat à cliver, les lignes de traçage étant perpendiculaires à l'axe longitudinal des bandes de transport, des moyens d'entraînement pour entraîner lesdites bandes de transport et avancer avec elles ledit substrat autour d'un corps (52) présentant une surface circulaire de rayon important afin d'appliquer une force appropriée pour provoquer le clivage de la tranche (11) à chaque ligne de traçage (15), ledit dispositif étant caractérisé en ce que:
- le rayon R de ladite surface incurvée est tel que la relation L : R entre la longueur de la barre de laser L, c'est à dire la distance entre deux lignes de traçage voisines, et le rayon R de ladite surface incurvée, est comprise entre 1/10 et 1/50,
- lesdites bandes de transport sont tendues de façon que les barres de laser tout en étant toujours appliquées contre la surface incurvée, soient automatiquement positionnées au moyen de la tension définie dans lesdites bandes de transport et de la courbure de la surface de rayon important, de maniére que les facettes clivées des barres de laser voisines soient séparées pour éviter leur endommagement mutuel, et le dispositif comprenant:
- des moyens de transport qui sont utilisés pour avancer plus loin lesdites barres de laser à une station d'évaporation où un revêtement est appliqué aux facettes tout en maintenant les barres voisines séparées

12. Un dispositif selon la revendication 11 dans lequel ledit corps présentant une surface incurvée, est un rouleau (52).

13. Un dispositif selon la revendication 11 dans lequel la largeur de la bande de transport inférieure (51) est au moins aussi large que la tranche (11) tandis que la bande de transport supérieure (56) est composée de une ou deux bandes (13A, 13B), chacune d'elles étant substantiellement plus étroite que la tranche.

14. Un dispositif selon la revendication 11 dans lequel les bandes de transport flexibles sont composées d'un matériau élastique.

15. Un dispositif selon la revendication 11 dans lequel les bandes de transport inférieure et supérieure (51, 56) sont guidées autour des rouleaux (52 et 53, 56 et 57) de façon à permettre l'insertion et la retenue de la tranche jusqu'au clivage et ensuite le relâchement automatique des barres clivées.

16. Un dispositif selon la revendication 15 dans lequel l'une des bandes de transport (51) est avancée au moyen de l'entraînement de l'un des rouleaux associés (52) tandis que l'autre bande de transport (56) est avancée par le frottement entre les deux bandes de transport (51, 56).

17. Un dispositif selon la revendication 15 dans lequel une courroie de transport séparée (41) avec des crochets (42) est prévue pour accrocher lesdites barres clivées relâchées (22) et pour les transporter dans un magasin (65) où elles seront stockées tout en restant séparées les unes des autres.
